Europäisches Patentamt

European Patent Office

Office européen des brevets

(19)

(11) Veröffentlichungsnummer: **0 560 123 A2**

## (12) EUROPÄISCHE PATENTANMELDUNG

(21) Anmeldenummer: **93102867.4**

(22) Anmeldetag: **24.02.93**

(51) Int. Cl.5: **H01L 29/73**

(30) Priorität: **12.03.92 DE 4207909**

(43) Veröffentlichungstag der Anmeldung:
**15.09.93 Patentblatt 93/37**

(84) Benannte Vertragsstaaten:
**DE FR GB IT**

(71) Anmelder: **SIEMENS AKTIENGESELLSCHAFT**
**Wittelsbacherplatz 2**
**D-80312 München(DE)**

(72) Erfinder: **Schaper, Ulrich, Dr.**
**Philipp-Foltz-Strasse 33**
**W-8000 München 83(DE)**
Erfinder: **Holzapfel, Birgit**
**Veroneser Strasse 8**
**W-8000 München 90(DE)**

(54) **Leistungstransistor mit Multifingerkontakten.**

(57) Leistungstransistor mit einer Mehrzahl kontaktierter Einzeltransistoren, bei dem die Kontakte dieser Einzeltransistoren in solchen Abständen untereinander angeordnet sind, daß eine für den vorgesehenen Leistungsbereich des Transistors ausreichend gleichmäßige Temperaturverteilung im Betrieb resultiert.

FIG 2

EP 0 560 123 A2

Die vorliegende Erfindung betrifft einen Leistungstransistor mit einer Mehrzahl aktiver Transistorgebiete, einen sogenannten Multifingertransistor.

Leistungstransistoren bestehen üblicherweise aus mehrfach nebeneinander integrierten Einzeltransistoren, die mit fingerförmigen Kontakten versehen sind. Daher werden diese Leistungstransistoren üblicherweise als Multifingertransistoren bezeichnet. Durch die Aneinanderreihung erreicht man eine gegenüber einzelnen Transistoren höhere Ausgangsleistung. Ein solcher fingerförmiger Kontakt kann zu dem Gate eines Feldeffekttransistors (insbesondere HEMT) oder zu einem Emitter eines Bipolartransistors führen.

Leistungstransistoren geben während ihres Betriebes Verlustleistung als Wärme ab. Bei den genannten Multifingertransistoren führt dies zu einer Überhitzung der mittleren Transistoren einer Reihe von Einzeltransistoren gegenüber den jeweils außenliegenden Transistoren. Bisher wurde die ungleichmäßige Erwärmung der Einzeltransistoren bei Multifingertransistoren meßtechnisch erfaßt, analysiert und durch theoretische Modelle beschrieben. Durch elektrische Schaltungsmaßnahmen wie z. B. Widerstände im Emitterkreis kann eine ungleichmäßige Erwärmung kompensiert werden (s. z. B. G.-B. Gao et al. "Thermal Design Studies of High Power Heterojunction Bipolar Transistors" IEEE Trans. ED-36 (5) 1989 pp. 854 und G.-B. Gao et al. "Emitter Ballasting Resistor Design for, and Current Handling Capability of AlGaAs/GaAs Power Heterojunction Bipolar Transistors" IEEE Trans. ED-38 (2), 1991, pp. 185). Die zulässige Höchsttemperatur für die in der Mitte einer Reihe liegenden Einzeltransistoren begrenzt die maximale Leistungsaufnahme des Multifingertransistors.

Beim Design integrierter Schaltungen wird generell versucht, temperaturempfindliche Schaltungsteile auf Isothermen zu plazieren (s. z. B. G.-B. Gao et al. "Uniform junction temperature of AlGaAs/GaAs Power Heterojunction Bipolar Transistors on Silicon Substrate" Appl. Phys. Lett. 58 (10) March 1991, pp. 1068).

Je geringer die Wärmeleitfähigkeit des betreffenden Halbleitermateriales ist, umso ungleichmäßiger erfolgt die Erwärmung der Einzeltransistoren. Wegen der geringeren Wärmeleitfähigkeit des Galliumarsenids (GaAs) gegenüber Silizium ist daher bei Verwendung von GaAs eine ungleichmäßigere Erwärmung als bei Silizium zu erwarten. Die verschiedenen Wärmeleitkoeffizienten für Halbleitermaterialien sind den einschlägigen Tabellenwerken zu entnehmen.

Aktive Transistorgebiete, insbesondere solche von Leistungstransistoren, stellen Wärmequellen dar, die praktisch nur zweidimensional an einer Oberfläche des Halbleiterkörpers vorhanden sind.

In R. D. Lindsted, R.J. Surty "Steady State Junction Temperatures of Semiconductor Chips" IEEE Trans. ED-19(1), 1972, pp. 41 ist eine Berechnung für eine dreidimensionale statische Temperatursimulation beschrieben, aus der sich die Temperaturverteilung auf der Halbleiteroberfläche, auf der in diesem Fall ein Einzeltransistor vorhanden ist, ergibt. Die dritte, senkrecht dazu liegende Raumdimension wird zur Beschreibung der Wärmeabfuhr über Kühlkörper benötigt.

Aufgabe der vorliegenden Erfindung ist es, Konfigurationen für Leistungstransistoren mit Mehrfachkontaktierung anzugeben, bei denen eine ausreichend gleichmäßige Erwärmung der Einzeltransistoren gegeben ist.

Diese Aufgabe wird mit dem Leistungstransistor mit den Merkmalen des Anspruches 1 gelöst. Weitere Ausgestaltungen ergeben sich aus den abhängigen Ansprüchen.

Die erfindungsgemäße Ausgestaltung des Leistungstransistors beruht auf der Erkenntnis, daß die ungleichmäßige Erwärmung bei gleichmäßig belasteten Einzeltransistoren auf dem gleichen Abstand der fingerförmigen Kontakte untereinander beruht. Mit einer Simulationsrechnung für die Temperaturverteilung lassen sich die Abstände der Kontakte der Einzeltransistoren in einem Multifingertransistor so bestimmen, daß für alle Einzeltransistoren zumindest näherungsweise die gleiche Maximaltemperatur bei Betrieb in einem vorgegebenen Bereich der elektrischen Nutzleistung erreicht wird. Diese gleichmäßige Temperaturverteilung erhöht die Effizienz des Gesamttransistors und schützt vor einer teilweisen Überhitzung des Multifingertransistors.

Es folgt eine Beschreibung des erfindungsgemäßen Leistungstransistors anhand der Figuren 1 bis 3.

Fig. 1 und 2     zeigen die Anordnungen der Kontakte für zwei Ausführungsformen des erfindungsgemäßen Transistors.

Fig. 3     zeigt in perspektivischer Aufsicht einen mit zwei Kontakten versehenen Halbleiterkörper mit eingezeichneten Bezugszeichen für verschiedene Bemessungen.

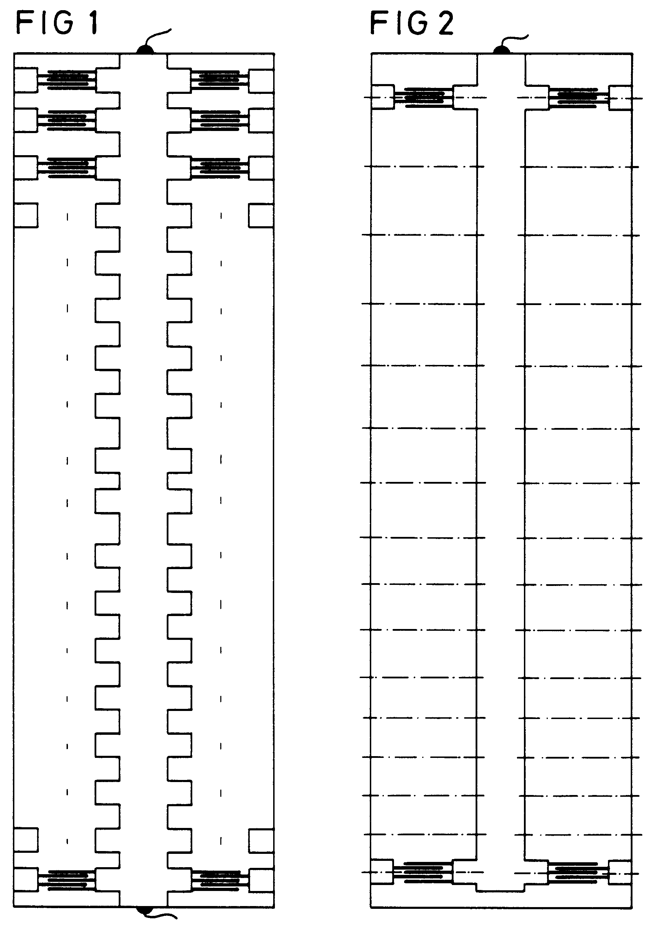

Bei dem erfindungsgemäßen Leistungstransistor werden die Multifingerkontakte für jeden Einzeltransistor in solchen Abständen voneinander angeordnet, daß sich der Transistor zumindest näherungsweise gleichmäßig erwärmt, wenn er bei demjenigen Wert oder in demjenigen Bereich der elektrischen Nutzleistung betrieben wird, für den er vorgesehen ist. In Fig. 1 ist z. B. ein zentraler streifenförmiger und zinnen- oder sägezahnförmig berandeter Kontakt (z. B. Basis) eingezeichnet. Jeder dieser zinnenförmigen Ansätze läuft in drei Kontaktfinger aus, die sich jeweils mit zwei Kontaktfingern von gegenüberliegenden Kontakten (z. B. Emitter, Kellektor) verzahnen. Die Abstände dieser durch jeweils einen Satz von Kontaktfingern definierten Einzeltransistoren zum in der Reihe nachfolgenden variieren. In den Figuren sind der Übersichtlichkeit halber nur die Kontaktfinger am Anfang und am Ende der Reihe eingezeichnet und die restlichen durch Striche oder strichpunktierte Linien angedeutet. Bei der gezeigten Anordnung, bei der der zentrale Kontakt beidseitig an die Stromzuführung angeschlossen ist, würden sich die mittleren Einzeltransistoren stärker aufheizen als die am Rand befindlichen, wenn für die Transistoren untereinander wie derzeit üblich gleiche Abstände gewählt würden. Erfindungsgemäß werden die Abstände der Einzeltransistoren so eingerichtet, daß die Erwärmung näherungsweise gleichmäßig erfolgt, so daß über die gesamte Reihe von Einzeltransistoren hin sich im Betrieb näherungsweise die gleiche Temperatur einstellt. In diesem Ausführungsbeispiel sind wie erkennbar die Abstände der Transistoren untereinander näherungsweise gleich, mit Ausnahme der innersten und äußersten Einzeltransistoren einer Reihe. Die beiden jeweils innersten Transistoren sind näher zusammengerückt, so daß sich deren Abstand untereinander verringert und sich die Abstände zu den jeweils nach außen sich anschließenden Transistoren vergrößern. Die am Ende jeder Reihe befindlichen Transistoren sind ebenfalls näher an die übrigen herangerückt.

Bei der Ausführungsform nach Fig. 2 wird der Strom an den mittleren Kontakt nur an einer Seite angelegt. Hier ist es erfindungsgemäß zweckmäßig, wenn die dem Stromanschluß näher gelegenen Einzeltransistoren untereinander größere Abstände haben. Zum anderen Ende des zentralen Kontaktes hin nehmen die Abstände ständig ab. Damit ist dem Umstand Rechnung getragen, daß der Spannungsabfall längs des zentralen Kontaktes eine Verringerung der Einsatzspannung des Transistors bewirkt und daß diese Verringerung durch eine gezielte Erwärmung mittels kleinerer Kontaktabstände kompensiert wird.

Von den zweireihigen Kontaktanordnungen wie in den Figuren können auch mehrere parallel angeordnet sein und zu einem Transistor-Array zusammengefaßt werden. Dann werden zweckmäßig z. B. nebeneinanderliegende Kontakte versetzt zueinander angeordnet. Wesentlich für den erfindungsgemäßen Leistungstransistor ist in jedem Fall, daß eine durch die Anordnung der Kontakte definierte Translationssymmetrie in einer irgendwie festgelegten Richtung (z. B. streifenförmiger Zentralkontakt) oder eine entsprechend vorhandene Spiegelsymmetrie durch die Anordnung der Fingerkontakte der Einzeltransistoren derart gebrochen, d. h. aufgehoben ist (z. B. ungleichmäßige Abstände in der durch den streifenförmigen Kontakt gegebenen Längsrichtung), daß die Temperaturverteilung bei Betrieb des Transistors gleichmäßig erfolgt. Da eine irgendwie geartete ungleichmäßige oder unsymmetrische Anordnung der Einzelkontakte nicht notwendig zu einer gleichmäßigen Temperaturverteilung führt, ist es Zweckmäßig, wenn die Abstände der einzelnen Kontakte untereinander den physikalischen Gesetzmäßigkeiten Rechnung tragen.

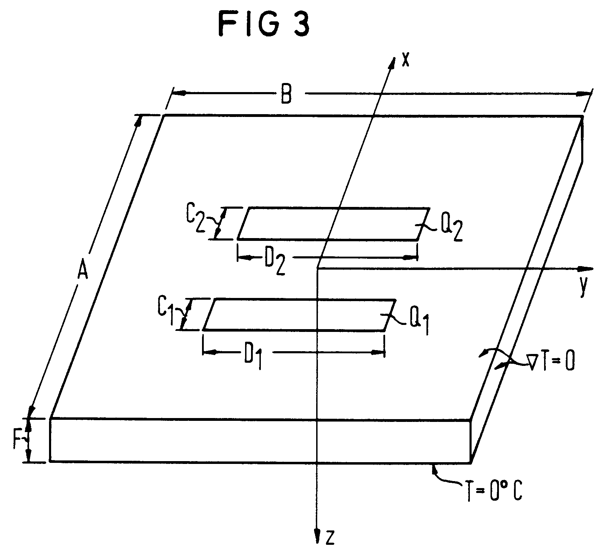

In Fig. 3 ist daher zur Erläuterung dieser physikalischen Grundlagen beispielhaft ein Halbleiterkörper in perspektivischer Aufsicht gezeichnet, auf dessen Oberfläche sich zwei Wärmequellen $Q_1$ und $Q_2$ (entsprechend den Kontakten) befinden. Dieser Halbleiterkörper in Form eines flachen Quaders habe die Abmessungen A und B sowie die Dicke F. Da auf der Rückseite des Leistungstransistors vorteilhaft eine Wärmesenke angebracht wird, bzw. der Transistor auf einer solchen Wärmesenke montiert wird, kann für die den Wärme-quellen gegenüberliegende Oberfläche eine konstante Temperatur (z. B. $0\,°C$) angenommen werden. Die restlichen Oberflächen des Halbleiterkörpers werden als gegenüber der Außenwelt thermisch isoliert angesehen ($\nabla T = 0$). Die Abmessungen $C_1$, $D_1$, $C_2$ und $D_2$ der als rechteckig angenommenen an der Oberfläche befindlichen Wärmequellen $Q_1$ und $Q_2$ sind ebenfalls eingezeichnet. Wenn der Transistor in Betrieb genommen wird, stellt sich nach einer bestimmten Anfangszeit eine statische Temperaturverteilung ein, für die die statische Wärmeleitungsgleichung $\Delta T = 0$ gilt. Diese Wärmeleitungsgleichung kann zum Berechnen der räumlichen Temperaturverteilung T (x, y, z) benutzt werden. Die sich aus den genannten Randbedingungen ergebenden Gleichungen gestatten die Integration dieser Wärmeleitungsgleichung. Die Randbedingungen lassen sich mathematisch so formulieren:

T = const. auf der Rückseite des Halbleiterkörpers;

$\nabla T$ = 0 auf der restlichen freien Oberfläche des Halbleiterkörpers;

$-\chi \nabla T = Q$ an den von den Wärmequellen eingenommenen Flächen, wobei Q jeweils $Q_1$ bzw. $Q_2$ ist. Der Wärmeleitkoeffizient $\chi$ ist vom Material des Halbleiterkörpers und der Temperatur abhängig. Die Wärmequellen ihrerseits sind abhängig von den beiden für sie maßgeblichen Raumkoordinaten. In Fig. 3 ist ein Koordinatensystem mit drei orthogonalen Richtungen eingezeichnet.

Um den erforderlichen Rechenaufwand für verschiedene mögliche Designs der Kontaktanordnung (einreihige, mehrreihige, rechteckige Anordnung) begrenzt zu halten, wird das angegebene Gleichungssystem vorteilhaft mittels der Methode der Fast-Fourier-Transformation (s. z. B. William H. Press e. a.: "Numerical Recipes. The Art of Scientific Computing", Cambridge University Press (1989)) numerisch gelöst. Die Rechnung, die in der Veröffentlichung IEEE Trans. ED-19, 41 (1972) angegeben ist und die nur für einen einzelnen Kontaktstreifen durchgeführt ist, läßt sich auf diese Weise für eine beliebige Anzahl und Anordnung von Kontakten auf der Transistoroberfläche durchführen. Die zu erwartende Wärmeverteilung läßt sich damit für im Prinzip beliebige Designs in effizienter Weise berechnen. Dazu ist nur erforderlich, daß für das vorgesehene Design die Verlustleistung eines einzelnen Kontaktfingers, die eben von dem Design bzw. der Konfiguration der Kontakte abhängt, für einen Probetransistor mit einer Messung bestimmt wurde. Diese Verlustleistung hängt auch von der vorgesehenen Nutzleistung ab. Es ist daher mit zu berücksichtigen, in welchem Bereich der elektrischen Nutzleistung der Transistor betrieben werden soll. Weitere Parameter, die für die Rechnung maßgeblich sind, sind die Abmessungen und die jeweilige Lage der Kontaktfinger (in Fig. 3 die x-y-z-Koordinaten und die Abmessungen $C_1$, $C_2$, $D_1$ und $D_2$) sowie die Abmessungen des Halbleiterkörpers A, B und F. Für Jedes Halbleitermaterial und Transistordesign läßt sich auf diese Weise die Temperaturverteilung für verschiedene Anordnungen der Kontakte für den vorgesehenen Leistungsbereich des Transistors bestimmen. Es läßt sich daher in systematischer Weise eine Anordnung der Kontakte bestimmen, bei der die Temperaturverteilung für die vorgesehene Leistung ausreichend gleichmäßig ist, um ein Überhitzen einzelner Transistoren zu vermeiden. Mit diesen numerischen Rechnungen lassen sich daher die verschiedenen Ausführungsformen des erfindungsgemäßen Leistungstransistors auf relativ einfache Weise für die jeweils vorgesehene Leistung des Transistors angeben. Umgekehrt ist es auch möglich, für ein vorgegebenes Ausführungsbeispiel und einen vorgesehenen Leistungsbereich die zu erwartende Temperaturverteilung zumindest näherungsweise zu bestimmen.

Der beschriebene Leistungstransistor (Bipolartransistor, FET, HEMT u. dgl.) gestattet auf einfache Weise, eine Vielzahl von Einzeltransistoren monolithisch integriert auf einem Halbleiterkörper unterzubringen, ohne daß die Leistung durch Überhitzung einzelner Transistoren begrenzt wird oder komplizierte schaltungstechnische Modifikationen notwendig wären. Ebenso ist es möglich, eine Mehrzahl solcher (Multifinger-) Leistungstransistoren integriert und ggf. mit gemeinsamen elektrischen Anschlüssen versehen z. B. in Reihen und Spalten als Array anzuordnen. Die im Array auftretenden Abstände von Leistungstransistoren zueinander sind dann erfindungsgemäß so angepaßt, daß eine über dieses Array gleichmäßige Temperaturverteilung erreicht ist, d. h. daß bei Betrieb des Arrays die Temperatur räumlich soweit konstant bleibt, daß keine die Funktionsweise einzelner Transistoren oder des gesamten Arrays beeinträchtigende Überhitzung einzelner Transistoren auftritt.

**Patentansprüche**

1. Leistungstransistor mit einer Mehrzahl monolithisch integrierter, kontaktierter und in einer Ebene angeordneter Einzeltransistoren, deren fingerförmige Kontakte so angeordnet sind, daß sie eine durch eine oder mehrere gemeinsame Kontaktflächen definierte Translations- oder Spiegelsymmetrie brechen und daß dadurch die Temperatur bei Betrieb des Leistungstransistors in einem vorbestimmten Bereich der elektrischen Nutzleistung in jeder Ebene, die parallel zu der Ebene der Anordnung der Einzeltransistoren liegt, zumindest soweit räumlich konstant bleibt, daß keine die Funktionsweise des Leistungstransistors beeinträchtigende Überhitzung eines Teils der vorhandenen Einzeltransistoren erfolgt.

2. Leistungstransistor nach Anspruch 1, bei dem die den Einzeltransistoren gegenüberliegende Oberfläche mit einer Wärmesenke verbunden ist und die restlichen Oberflächen zumindest näherungsweise thermisch isoliert sind und bei dem die Anordnung der fingerförmigen Kontakte einer numerischen Lösung der statischen Wärmeleitungsgleichung $\Delta T(x, y, z) = 0$ mittels Fast-Fourier-Analyse entspricht, wobei im Bereich der Kontakte die Gleichung $-\chi (T)\nabla T(x, y, 0) = Q (x, y, 0)$ mit einem material- und temperaturabhängigen Wärmeleitungskoeffizienten $\chi$ und ortsabhängigen Wärmequellen Q als Randbedingung fungiert.

3. Leistungstransistor nach Anspruch 1 oder 2, bei dem fingerförmige Kontakte lateral längs einer streifenförmigen Kontaktfläche, für die eine Stromzuführung nur an einem Ende vorgesehen ist, angeordnet sind und bei dem die Abstände aufeinanderfolgender Kontakte von dem für die Stromzuführung vorgesehenen Ende der Kontaktfläche zu dem anderen Ende hin streng monoton abnehmen.

4. Leistungstransistor nach Anspruch 1 oder 2, bei dem fingerförmige Kontakte lateral längs einer streifenförmigen Kontaktfläche, für die eine Stromzuführung an beiden Enden vorgesehen ist, angeordnet sind und bei dem die Abstände von in Längsrichtung dieser Kontaktfläche aufeinanderfolgender Kontakte untereinander variieren und bezüglich einer senkrecht zur Längsrichtung der streifenförmigen Kontaktfläche durch deren Mitte verlaufenden Geraden spiegelsymmetrisch sind.

5. Leistungstransistor nach Anspruch 4, bei dem die Abstände der in der Längsrichtung in einer jeweiligen Reihe aufeinanderfolgenden fingerförmigen Kontakte mit Ausnahme der in der Mitte und an den Enden vorhandenen Abstände näherungsweise gleich sind, aber zwei mittlere Kontakte hintereinander einen demgegenüber geringeren Abstand und zu den in beiden Richtungen folgenden Kontakten einen demgegenüber größeren Abstand haben und die an den Enden befindlichen Kontakte zu dem jeweils folgenden Kontakt einen demgegenüber geringeren Abstand haben.

6. Array aus mehreren Leistungstransistoren nach jeweils einem der Ansprüche 1 bis 5, die gemeinsam integriert und mit elektrischen Anschlüssen versehen sind und die zueinander in solchen Abständen angeordnet sind, daß die Temperatur bei Betrieb des Arrays soweit räumlich konstant bleibt, daß keine die Funktionsweise des Arrays beeinträchtigende Überhitzung einzelner Leistungstransistoren auftritt.

EP 0 560 123 A2

FIG 1

FIG 2

6

# FIG 3